# EUROPEAN PATENT APPLICATION

(11) **EP 2 618 050 A2**
(43) Date of publication of application: **24.07.2013**
(21) Application number: 11825425.9
(22) Date of filing: 14.09.2011
(51) Int. Cl.: F21V 29/00, F21Y 101/02

(54) **LED LIGHT SOURCE STRUCTURE WITH HIGH ILLUMINATING POWER AND IMPROVED HEAT DISSIPATING CHARACTERISTICS**

(30) Priority: 16.02.2011 KR 20110013577; 13.09.2010 KR 20100089576
(71) Applicant: BK Technology Co., Ltd., Seoul 120-818 (KR)
(72) Inventor: LEE, Dong Woo, Seoul 120-818 (KR)
(74) Representative: Hall, Matthew Benjamin
(86) International application number: PCT/KR2011/006783
(87) International publication number: WO 2012/036465

(57) **Abstract**

The present invention relates to an LED light source structure, and more particularly, to an LED light source structure with high illuminating power and improved heat dissipating characteristics, in which metal having superior electric conductivity and thermal conductivity is processed into positive electrode units, and heat generated from an LED chip is directly dissipated through the electrode unit which is used as a positive electrode from among the positive electrode units, thereby improving heat dissipating characteristics, stabilizing a light source and preventing voltage drop, thus enabling output of high illuminating power. The LED light source structure with high illuminating power and improved heat dissipating characteristics is configured in that the LED chip is arranged and heat generated when the LED chip is turned on is dissipated to the outside, wherein the LED light source structure comprises: a first electrode unit 10 made of an electrically conductive material; a second electrode unit 20 made of an electrically conductive and thermally conductive material and electrically insulated from the first electrode unit 10; and an LED chip 40 arranged to use the first electrode unit 10 and the second electrode unit 20 as a positive electrode, wherein the first electrode unit 10 and the second electrode unit 20 are arranged to be brought into surface-contact with the LED chip 40, thus enabling heat generated from the LED chip 40 to be directly conducted and dissipated into the atmosphere.

## Description

### [Technical Field]

The present invention relates to an LED light source structure, and particularly, to an LED light source structure with high illuminating power and improved heat dissipation performance that can improve the heat dissipation performance by manufacturing both electrode units by processing metal which is excellent in electric conductivity and thermal conductivity and directly dissipating heat generated from an LED chip through the electrode unit by using one electrode unit thereof and output high illuminating power by stabilizing a light source and preventing a voltage drop.

### [Background Art]

A light emitting diode (LED) is a semiconductor element that emits light when voltage is applied in a forward direction and when voltage is applied to the LED, energy of electrons on a PN junction surface of the LED is converted into light energy to emit light.

The LED may emit light with various colors according to a semiconductor material, have a fast response time to input voltage, may be mass-produced at a low cost due to a simple structure, and may be manufactured in a small size because a filament is not used like a light bulb. Further, since the LED is strong on vibration and has a long lift span because a trouble probability is low, the LED has been widely used as a light source by substituting for an illumination mechanism such as the light bulb or a fluorescent lamp in the related art.

A light source using the LED has a characteristic in which light power and light efficiency are maximized when the temperature of the diode is maintained to a proper activity temperature of electrons (approximately 25 to 55°C). The LED generates photons and heat when electrons are moved by electromagnetic induction (electricity) due to the characteristics and in this case, the photons and the heat are in inverse proportion to each other. Therefore, generation of the photons may be increased and durability of the diode may also be maintained according to how soon the heat generated from the inside of the LED is dissipated.

That is, activity of the electrons is increased by heat generated when the electrons are moved by electric energy, and as a result, electric resistance is decreased. In addition, generation of the photons by the electric energy is decreased except for heat required for appropriate activity of the electrons, excessive activity of the electrons due to heat (an increase in current amount) deteriorates binding force of an atom structure to decrease mobility (voltage) of the electrons which the diode may afford, and as a result, the LED is broken and even fire may occur.

The heat generation problem primarily occurs when an LED light source generally used for an illumination is manufactured, and a heat radiant plate is required to rapidly radiate accumulated heat other than heat required to for activity of the electrons which is generated from the LED.

In general, an LED light source structure is configured by mounting an LED chip or package on a printed circuit board (PCB) constituted by a metallic heat radiant plate, an insulator formed on the heat radiant plate, and a copper foil circuit layer formed on the top of the insulator. In the LED light source structure in the related art, current is input into a positive (+) electrode of the LED chip through the copper foil circuit layer and output to a negative (-) electrode through the LED chip to thereby emit light.

In the LED light source in the related art, since a direct large area and conductivity of an electric circuit cannot be increased due to the limitation of the thin copper foil circuit layer, an indirect heat radiant method of transferring current resistance generated in the LED chip and the circuit and emitting heat generated simultaneously when the photons are generated in the LED chip, toward a plate for the heat radiation through a lower insulator is used. Therefore, there is a limit in implementing a LED light source with high illuminating power because heat cannot be effectively radiated as compared with the generated heat.

Due to this problem, a scheme has been recently proposed, which can increase a heat radiation efficiency by transferring the heat generated from the LED chip directly to the plate for heat radiation without passing through the insulator by etching the insulator formed on the top of the heat radiant plate and mounting the LED chip on the top of the insulator. However, even in this method, since heat is transferred to the plate for heat radiation through the insulator formed in the LED chip or package itself and a soldering layer connecting the LED chip and the heat radiant plate, there has yet been present a limit that the heat radiant effect deteriorates.

### [Disclosure]

### [Technical Problem]

The present invention is contrived to solve the problems in the related art, and an object of the present invention is to provide an LED light source structure with high illuminating power and improved heat dissipation performance that can efficiently dissipate heat generated when an LED light source is driven.

Another object of the present invention is to provide an LED light source structure with high illuminating power and heat dissipation performance that can improve the heat dissipation performance by emitting heat generated from an LED light source through a heat sink by directly using a heat sink including a metallic body which is excellent in electric conductivity and thermal conductivity as a positive electrode of the LED light source.

Yet another object of the present invention is to provide an LED light source structure with high illuminating power and heat dissipation performance for improving heat dissipation performance and preventing voltage drop, which can prevent voltage drop and power of generated light when an LED light source is driven.

Still another object of the present invention is to provide an LED light source structure with high illuminating power and heat dissipation performance that can vary a light amount as necessary by individually using an LED light source structure or easily connecting a plurality of LED light source structures.

### [Technical Solution]

In order to achieve the aforementioned objects, a light source structure for a light emitting diode (LED), in which an LED chip is installed and toward outside of which a heat generated by light-on of the LED chip is emitted thereby accomplishing high illuminating power and improved heat dissipation performance, includes: a first electrode unit 10 including an electrically conductive material; a second electrode unit 20 including an electrically conductive and thermally conductive material and thermal conductivity and electrically insulated from the first electrode unit 10; and an LED chip 40 installed to use the first electrode unit 10 and the second electrode unit 20 as both electrodes, wherein the first electrode unit 10 and/or the second electrode unit 20 surface-contact the LED chip 40 to allow heat generated from the LED chip 40 to be directly conducted and dissipated toward an atmosphere.

In this case, wherein the first electrode unit 10 is provided with one or more first electrode connectors 11 at one end or both ends thereof, provided with one or more through-holes 12, and includes a first electrode section 13 formed on the top of the first electrode unit 10 adjacent to the through-hole 12, and an insulating layer is formed at least on the bottom of the first electrode unit 10 in an area other than the first electrode connector 11. The second electrode unit 20 is provided with one or more second electrode connectors 21 at one end or both ends thereof to be in close contact with a lower part of the first electrode unit. On the first electrode unit 10, an insulator 30 with electrically non-conductivity in which electrode connection holes 33 corresponding to the through-hole 12 and the first electrode section 13 are formed is stacked, and the LED chip is mounted on the insulator 30 to be connected to the first electrode unit 10 by the first electrode section 13 through the electrode connection hole 33 and connected to the second electrode unit 20 through the through-hole 12.

In this case, the first electrode connector, the first electrode section, and at least a portion of the second electrode unit 20 which corresponds to the through-hole 12 are provided with plated layers for improving electric conductivity.

In the insulator, a portion on which the LED chip is mounted is dented in form of a concave hemisphere and an electrode connection hole is formed at the dented center, and in the second electrode unit, a second electrode section is formed to be protruded toward the through-hole by increasing a mounting height of the LED chip thereby improving light output.

In this case, the second electrode section is formed to be protruded by applying pressure to a rear surface of the second electrode unit and a protruding height thereof is preferably 2/3 equal to or less than the thickness of the second electrode unit.

Further, a plated layer may be additionally formed on the top of the second electrode section in order to improve electric conductivity between the LED chip and the second electrode unit.

Preferably, the first electrode is a negative electrode and the second electrode is a positive electrode.

Further, in the first electrode unit or the second electrode unit, a cross-sectional area of an electrode unit in which a large amount of heat is transferred from the LED chip is larger than that of another electrode unit.

The first electrode connector may be formed at only one end of the first electrode unit and the second electrode connector may be formed at only the other end of the second electrode unit corresponding to the other end of the first electrode unit so that the first electrode connector is connected with a second electrode connector of the adjacent LED light source structure, the second electrode connector is connected with a first electrode connector of another adjacent LED light source structure to connect one LED light source structure with one or more adjacent LED light source structures.

The second electrode unit 20 may be formed to have a heat sink shape so that the heat generated from the LED chip 40 is emitted through the heat sink-shaped second electrode unit 20.

In an upper part of the second electrode unit, a groove is formed to install first electrode unit and the insulator so that the height of the first electrode unit is horizontal to an upper height of the heat sink-shaped second electrode unit.

In this case, in the upper part of the first electrode unit and the upper part of the second electrode unit, a plurality of positive terminals and negative terminal are formed to connect positive electrodes and negative electrodes of the plurality of LED chips.

Alternatively, a heat sink 60 which is a metallic body having electric conductivity and thermal conductivity may be provided, an upper part of the heat sink 60 is coated with an insulating material 66 including a transparent material, the second electrode unit 20 is installed in the upper part of the heat sink 60, the first electrode unit 10 is installed in the upper part of the second electrode unit 20 to be insulated from the second electrode unit 20 and the heat sink 60 so that the heat generated from the LED chip 40 is emitted through the heat sink 60 contacting the second electrode unit 20.

An exterior of the heat sink in the upper part may be coated with an insulating material having a heat dissipation function and an insulating function in order to prevent a short circuit.

The heat sink may preferably include a material having electric conductivity and thermal conductivity.

### [Advantageous Effects]

According to an LED light source structure with high illuminating power and heat dissipation performance of the present invention, voltage drop can be minimized by maximizing a cross-sectional area of an electrode part on which an LED chip is mounted and heat generated from the LED chip can be emitted within a shortest time.

In more detail, the flow of electrons that flow through an electrode unit can be maximized by maximizing a cross-sectional area of an electrode and decreasing the length of the electrode to minimize resistance, and as a result, the voltage drop can be minimized so as to maximally correspond to surface resistance generated on the surface of the LED chip while the flow of the electrons is improved.

Further, according to the present invention, a primary huge passage for heat transfer and a passage for electron flow in which resistance is minimized due to a maximized electrode unit may be guaranteed and thermal equilibrium between the LED chip and a positive electrode is rapidly achieved while increasing a cross-sectional area of an electrode, in particular, a positive electrode which directly contacts the LED chip in a large area. Therefore, a problem in which the temperature of an LED active layer is rapidly increased can be solved, resistance of the LED chip is stabilized and thus current is stabilized, and as a result, driving by constant current can be easily implemented at the time of designing a converter.

Further, according to the present invention, since amount of light can be varied as necessary by individually using an LED light source structure or easily connecting a plurality of LED light source structures, various forms and amounts of light can be implemented.

Further, when a plurality of LED chips are installed on each electrode unit with good electrical conductivity at a regular interval and a remaining part is insulatively coated and manufactured in a circuit board form, various complicated processes are not required, and as a result, a substrate having a multi-channel light source which is low in terms of a cost and is simplified can be manufactured, and small holes are formed on the circuit board at a regular interval and the circuit board is cleanly cut along the holes with a size and a shape which a user requests, and as a result, a power supply is connected to the cut circuit board to be easily used.

### [Description of Drawings]

FIG. 1 is a conceptual diagram illustrating the structure of an LED light source structure according to a first embodiment of the present invention.

FIG. 2 is a perspective view illustrating a component of the LED light source structure according to the first embodiment.

FIG. 3 is an exploded perspective view illustrating the component of the LED light source structure according to the first embodiment.

FIG. 4 is a cross-sectional view taken along line A-A' of FIG. 2.

FIG. 5 is a cross-sectional view taken along line B-B' of FIG. 2.

FIG. 6 is a perspective view illustrating a state in which a plurality of LED light source structures is coupled with each other according to the first embodiment.

FIG. 7 is a cross-sectional view illustrating an LED light source structure according to a second embodiment of the present invention.

FIG. 8 is a perspective view of an LED light source structure according to a third embodiment of the present invention.

FIG. 9 is a side view of the LED light source structure according to the third embodiment of the present invention.

FIG. 10 is an exploded perspective view of the LED light source structure according to the third embodiment of the present invention.

FIG. 11 is a side cross-sectional view of the LED light source structure according to the third embodiment of the present invention.

FIG. 12 is a plan view of the LED light source structure according to the third embodiment of the present invention.

FIG. 13 is a perspective view of an LED light source structure according to a fourth embodiment of the present invention.

FIG. 14 is an exploded perspective view of the LED light source structure according to the fourth embodiment of the present invention.

FIG. 15 is a side cross-sectional view of the LED light source structure according to the fourth embodiment of the present invention.

### [Mode for Invention]

Hereinafter, embodiments of the present invention will be described in detail with reference to the accompanying drawings.

The present invention, as an LED light source structure that can rapidly emit heat generated by light-on of an LED chip to the outside, includes a first electrode unit 10 including a material having electric conductivity, a second electrode unit 20 positioned below the first electrode unit 10, including a material having electric conductivity and thermal conductivity, and electrically insulated from the first electrode unit 10, and an LED chip 40 connected with the first electrode unit 10 and the second electrode unit 20, in which heat generated from the LED chip 40 is directly transferred to the first electrode unit 10 and/or the second electrode unit 20 to be emitted to the air through the first electrode unit 10 and/or the second electrode unit 20 by using the first electrode unit 10 and the second electrode unit 20 as both electrodes of the LED chip 40.

In the present invention, the materials of the first electrode unit 10 and the second electrode 20 are formed by a metallic body having electric conductivity and thermal conductivity as an embodiment, but may include a material having electric conductivity and thermal conductivity, such as graphite or graphene, even not the metallic body.

Thermal conduction resistance and electric conduction resistance need to be minimized by maximizing an area of a connection unit between the first electrode unit 10 or the second electrode unit 20 and the LED chip 40 so as to smoothly emit the heat generated from the LED chip 40 through the first electrode unit 10 or the second electrode unit 20.

In detail, one unit selected from the first electrode unit 10 and the second electrode unit 20 or both of the first electrode unit 10 and the second electrode unit 20 not dot-contact but surface-contact the LED chip 40 to minimize the thermal conduction resistance and the electric conduction resistance, and the heat generated from the LED chip 40 may be emitted through the first electrode unit 10 or the second electrode unit 20 or both the first electrode unit 10 and the second electrode unit 20.

The present invention may be implemented in various forms by using the aforementioned configuration and principle, but will be described based on four representative embodiments.

<First Embodiment>

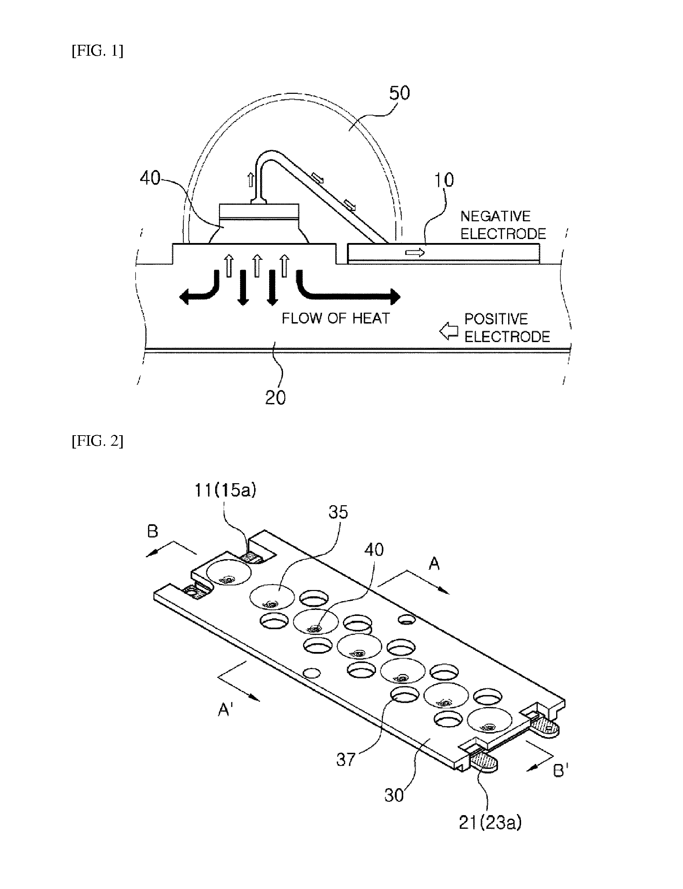

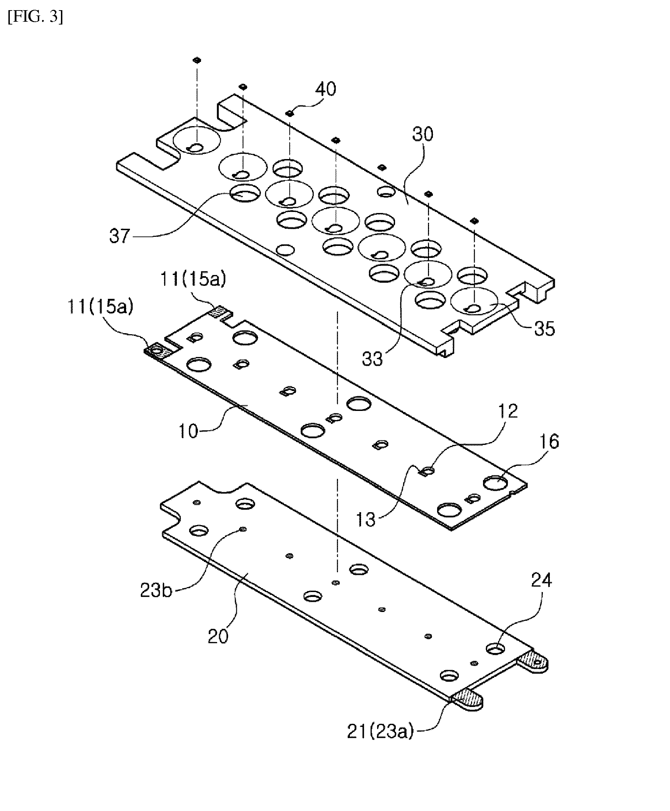

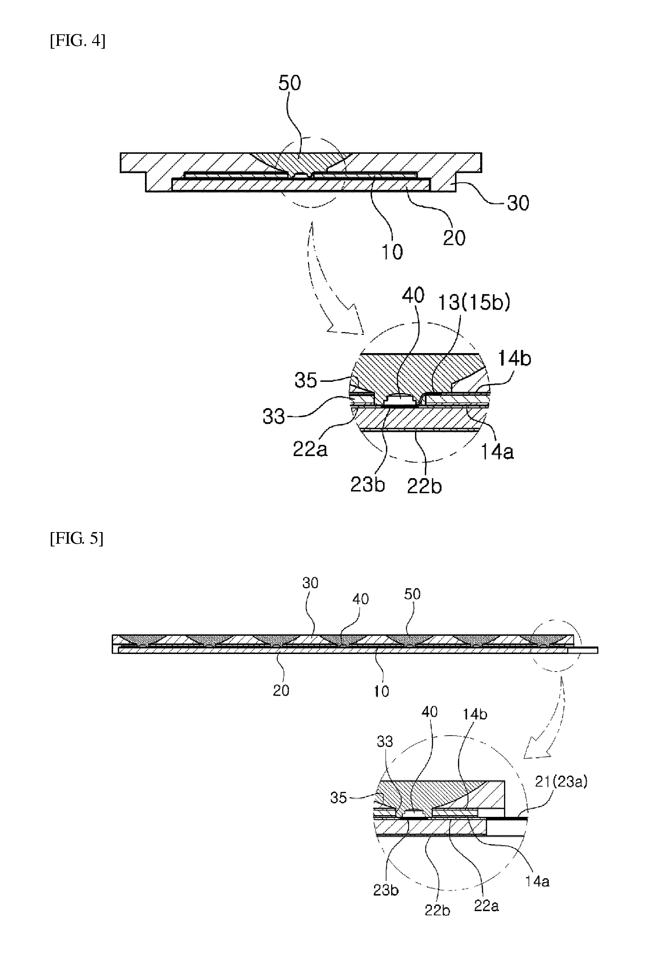

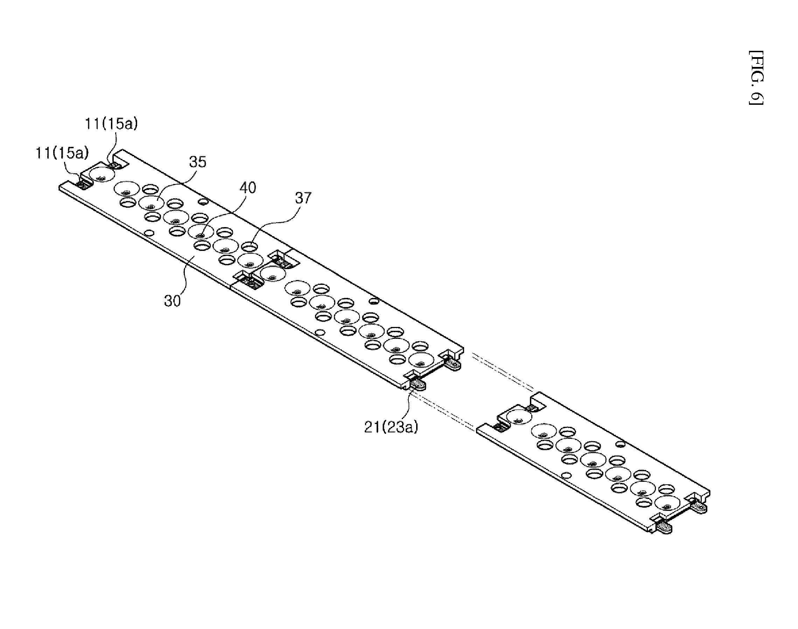

FIG. 1 is a conceptual diagram illustrating the structure of an LED light source structure with improved heat dissipation performance according to a first embodiment of the present invention. FIG. 2 is a perspective view illustrating a component of the LED light source structure according to the first embodiment. FIG. 3 is an exploded perspective view illustrating the component of the LED light source structure according to the first embodiment. FIG. 4 is a cross-sectional view taken along line A-A' of FIG. 2. FIG. 5 is a cross-sectional view taken along line B-B' of FIG. 2. FIG. 6 is a perspective view illustrating a state in which a plurality of LED light source structures is coupled with each other according to the first embodiment.

As illustrated in the figure, the LED light source structure according to the present invention includes a first electrode unit 10 and a second electrode unit 20 formed by a metallic body which is excellent in electric conductivity and thermal conductivity, an electrical non-conductive insulator 30, and an LED chip 40.

In more detail, in the first electrode unit 10 including a material having electric conductivity, one or more first electrode connectors 11 are provided at one end or both ends thereof so that current depending on a first electrode is conducted, one or more through-holes 12 are formed, and a first electrode section 13 adjacent to the through-holes 12 are provided on the top of the first electrode unit 10, and an insulating layer 14a is formed in an area other than the first electrode connector 11 at the bottom thereof.

A plated layer 15a for improving electric conductivity with a connection terminal with a power supply or the first electrode connector 11 of an adjacent LED light source structure may be formed in the first electrode connector 11.

Further, a plated layer 15b for improving electric conductivity with the LED chip 40 may be formed even in the first electrode section 13. In this case, an insulating layer 14b may be additionally formed in an area other than the first electrode unit 13 where the plated layer 15b is formed, on the top of the first electrode unit 10.

Moreover, the first electrode connector 11 may be provided at both ends of the first electrode unit 10, but provided at only one end. A second electrode connector 21 is disposed at the other end of the second electrode unit 20 corresponding to the other end of the first electrode unit 10, and as a result, the LED light source structures according to the present invention may have an electric connection relationship while being joined to each other.

Meanwhile, in the second electrode unit 20 including the material having electric conductivity, one or more second electrode connectors 21 are provided at one end or both ends and are in close contact with a lower side of the first electrode unit 10 so that current depending on a second electrode is conducted.

In this case, since the insulating layer 14a is formed in the lower side of the first electrode unit 10 which is in close contact with the second electrode unit 20 and thus, the first electrode unit 10 and the second electrode unit 20 are insulated from each other, an additional insulator needs not be formed on the top of the second electrode unit 20. However, in the embodiment, an insulating layer 22a is formed on the top of the second electrode unit 20 for a stable operation of the LED light source structure, however, the insulating layer 22a is not formed in portions corresponding to the second electrode connector 21 and the through-hole 12 of the first electrode unit 10. In addition, plated layers 23a and 23b for improving electric conductivity may be formed in the portions where the insulating layer 22a is not formed.

Further, an additional insulating layer is not required even in the lower side of the second electrode unit 20, but an insulating layer 22b may be additionally formed as in the embodiment.

In addition, the second electrode connector 21 may be provided at both ends of the second electrode unit 20, but provided at only one end. The first electrode connector 11 is disposed at one end of the first electrode unit 10 and the second electrode connector 21 is disposed at the other end of the second electrode unit 20 corresponding to the other end of the first electrode unit 10, and thus the plurality of LED light source structures according to the present invention are joined to each other.

Moreover, coupling holes 16 and 24 for coupling with the insulator 30 are formed in the first electrode unit 10 and the second electrode unit 20.

In addition, a negative electrode is connected to the first electrode unit 10, and a positive electrode is applied to the second electrode unit 20. In this case, when power is applied to the mounted LED chip 40, a large amount of heat of the LED chip 40 is generated toward the positive electrode, and thus, a cross-sectional area of the second electrode unit 20 may be manufactured to be larger than that of the first electrode unit 10 in order to enlarge a heat transfer passage.

The insulator 30 includes a material having electric non-conductivity, for example, plastics and is stacked on the first electrode unit 10. In addition, coupling protrusions (not illustrated) inserted into the coupling holes 16 and 24 formed in each electrode unit are provided in a lower side of the insulator 30 so that the first electrode unit 10 and the second electrode unit 20 which are sequentially stacked are coupled to the insulator 30.

In addition, one or more cut holes 37 for cost reduction may be formed in the insulator 30.

Further, an electrode connection hole 33 that is penetrated to correspond to the through-hole 12 and the first electrode section 13 is formed in the insulator 30. The electrode connection hole 33 is used to electrically connect the LED chip 40 mounted on the insulator 30 with the first electrode unit 10 and the second electrode unit 20, and a mounting portion 35 which is dented in a concave hemisphere shape in order to increase light efficiency of light emitted from the LED chip 40 and guide light emission to a front side is formed in the insulator 30, and the electrode connection hole 33 is formed at the center of the mounting portion 35.

In this case, since the mounting portion 35 has the concave hemisphere shape, the mounting portion 35 reflects the light emitted from the LED chip 40, which may face the front side, but a reflecting mirror may be attached to the mounting portion 35 in order to increase reflection efficiency.

Meanwhile, the LED chip 40 is mounted on the insulator 30 to be connected to the first electrode unit 10 by the first electrode section 13 through the electrode connection hole 33 and connected to the second electrode unit 20 through the through-hole 12. In this case, the LED chip 40 is in close contact with the second electrode unit 20 to be electrically connected with the second electrode unit 20 throughout the lower whole of the LED chip 40.

Further, a transparent encapsulant 50 covering the entirety of the mounting portion 35 is formed on the periphery of the LED chip 40. The encapsulant 50 may include an epoxy or silicon material and serves as a primary lens that primarily controls an orientation angle of the light emitted from the LED chip 40 while serving to encapsulate the LED chip 40.

Next, an operation of the LED light source structure with high illuminating power and improved heat dissipation performance according to the embodiment will be described.

In driving circuits of the LED chip in the related art, a printed circuit board (PCB) is manufactured in such a manner that an insulator for preventing short-circuit is disposed on a heat transfer plate including various material, a thin copper foil is compressed and printed thereon, and the copper foil is oxidized to leave only a circuit.

As well known, electricity is described by movement of free electros in a solid by electromagnetic induction discovered by Faraday. In addition, a semiconductor, as a special mechanism in which movement of electrons is arbitrarily maximized by using the movement of the electrons, needs a large electron movement circuit corresponding thereto.

However, in the PCB manufacturing method without considering the semiconductor characteristic, a maximized electron transfer amount may not be handled due to a significantly narrow circuit network implementation when a plurality of LED chips are connected to each other in series or in parallel, and thus voltage drop to durability fall of the circuit is caused. Furthermore, voltage is consistently dropped again by a current amount increased due to a characteristic of an activated semiconductor to reduce a life-span of the semiconductor.

Further, a complicated power system is implemented by adding a constant current control circuit to a constant voltage circuit in a driver (converter) of the LED chip due to the above phenomenon, and in this case, when a circuit having a large capacity is configured according to the characteristic of the LED, capacitance depending on the size of the LED may be naturally implemented, and as a result, smooth performance of the LED is drawn even by only constant voltage to simplify a complicated driving power system, thereby designing an inexpensive system and manufacturing an LED light source structure.

To this end, in the embodiment, electrodes having different polarities are connected to the first electrode unit 10 and a second electrode unit 20 which have good electric conductivity, and a part to which the semiconductor will be bonded is coated with plated layers 15b and 23b in each of the electrode units 10 and 20 to configure the circuit and a remaining part is insulatively coated. When a circuit board is manufactured in the same manner, various complicated processes of manufacturing the circuit board are not required, and as a result, the circuit board becomes inexpensive and simplified.

Further, the first electrode unit 10 and the second electrode unit 20 having different polarities overlap with each other and are bonded with the LED chip 40, and the negative electrode is applied to the first electrode unit 10 stacked on the top and the through-hole 12 is formed, and the second electrode unit 20 is assembled to be shown through the through-hole 12 and a polarity side where a large amount of the LED chip 40 is generated is manufactured to be thicker to remove dispersion of heat and various failures caused due to heat.

When an operation by application of power is described in more detail, positive power supplied to the second electrode unit 20 is supplied to the positive electrode of the LED chip 40 in the LED light source structure according to the embodiment and thus, moved to the negative electrode through the LED chip 40 and transferred to the first electrode unit 10, and as a result, the LED chip emits light and lights on.

Heat is generated from the LED chip 40 with light-on of the LED chip 40, and the heat is generated intensively from the positive electrode that generally generates photons. In the embodiment, since the positive electrode of the LED chip 40 is directly electrically connected with the second electrode unit 20 which is the metallic body and serves as a heat sink without the insulator, a large amount of heat generated from the positive electrode of the LED chip 40 is directly moved to the second electrode unit 20 and thus dissipated, and as a result, heat is exhausted instantly. Therefore, heat generated with light-on of the LED chip 40 is rapidly and effectively dissipated through the second electrode unit 20 to stabilize the LED light source, and since the second electrode unit 20 operates as the positive electrode of the LED chip 40, a space in which holes generated when the positive electrode of the LED chip emits light stay may be sufficiently secured to enable an LED light source with high illuminating power to be manufactured.

Further, in the embodiment, the first electrode connector 11 of the first electrode unit 10 is disposed at one end of the LED light source structure, and the second electrode connector 21 of the second electrode unit 20 is disposed at the other end. In this case, since the first electrode unit 10 and the second electrode unit 20 are sequentially stacked, the first electrode connector 11 is relatively higher than the second electrode connector 21 in terms of the position. Accordingly, when the second electrode connector 21 of the adjacent LED light source structure is connected to the first electrode connector 11, the first electrode connector 11 and the second electrode connector 21 overlap with each other to be connected with each other without positional interference.

Since a light amount can be varied as necessary by using individually an LED light source structure or easily connecting a plurality of LED light source structures to each other, various forms and light amounts may be implemented.

Moreover, in the embodiment, since the first electrode unit 10 and the second electrode unit 20 are formed in a comparatively thin panel form and the second electrode unit 20 serves as the heat sink, a heat dissipation design in which a weight is small while maximizing efficiency of the LED chip 40 may be performed. Further, in the embodiment, since a volume is not increased, but still decreased through omission of a heat dissipation mechanism, the LED light source structure may be applied to an optical structure in the related art without an additional structural change and a space for installing the light source may be reduced.

<Second Embodiment>

Next, a second embodiment of the LED light source structure with high illuminating power and improved heat dissipation performance according to the present invention will be described. In the embodiment, like reference numerals refer to like elements corresponding to those of the first embodiment.

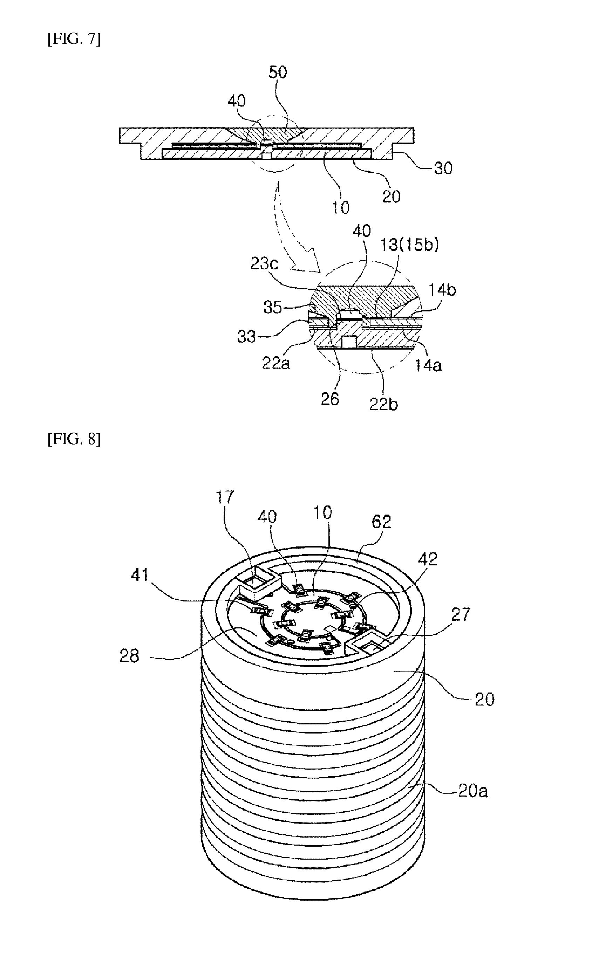

FIG. 7 is a cross-sectional view of an LED light source structure according to a second embodiment of the present invention and illustrates a modified form of the LED light source structure taken along line A-A' of FIG. 2.

As illustrated in the figure, in the embodiment, a second electrode section 26 that protrudes toward the through-hole 12 is formed in order to improve light output by increasing a mounting height of the LED chip 40 in the second electrode unit 20. In this case, the second electrode section 26 may be formed as the protrusion by using a panel having protrusions as the second electrode unit 20, but in the embodiment, the second electrode section 26 protrudes by applying pressure to a rear surface of the second electrode unit 20.

In this case, a protruding height of the second electrode section 26 from the top of the second electrode unit 20 may be 2/3 equal to or less than the thickness of the second electrode unit 20. Therefore, the second electrode section 26 and the second electrode unit 20 are not separated, when an unexpected shock is applied to the protruded second electrode section 26.

In addition, the second electrode section 26 may have a diameter smaller than a diameter of the through-hole 12 of the first electrode unit 10. This purpose is that the second electrode section 26 is spaced apart from the first electrode section 13 adjacent to the through-hole 12.

Further, a plated layer 23c may be additionally formed on the top of the second electrode section 26 in order to improve electric conductivity between the LED chip 40 and the second electrode unit 20.

When the LED chip 40 is mounted on the top of the second electrode section 26 configured as above, a mounting height of the LED chip 40 increases, and as a result, a light output surface is heightened and thus light is absorbed in a hemisphere-shaped mounting portion 35 of the first electrode unit 10, thereby preventing the light output from deteriorating.

In other words, in the embodiment, the output of light generated from the LED chip 40 may be prevented from deteriorating by adopting a structure of heightening the position of the LED chip 40, and as a result, the light output may be improved and energy may be saved due to prevention of light loss.

<Third Embodiment>

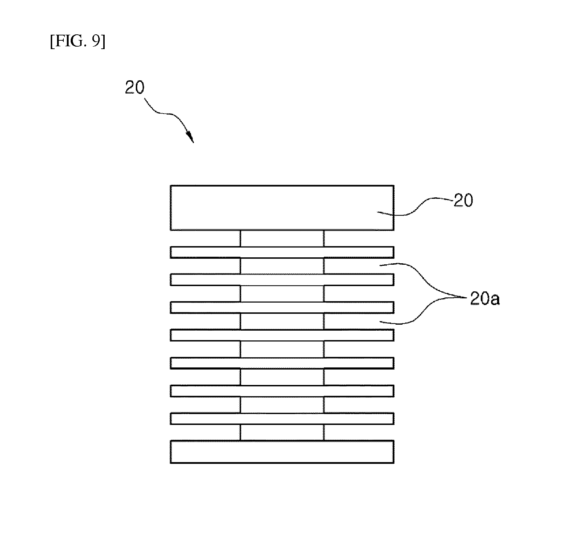

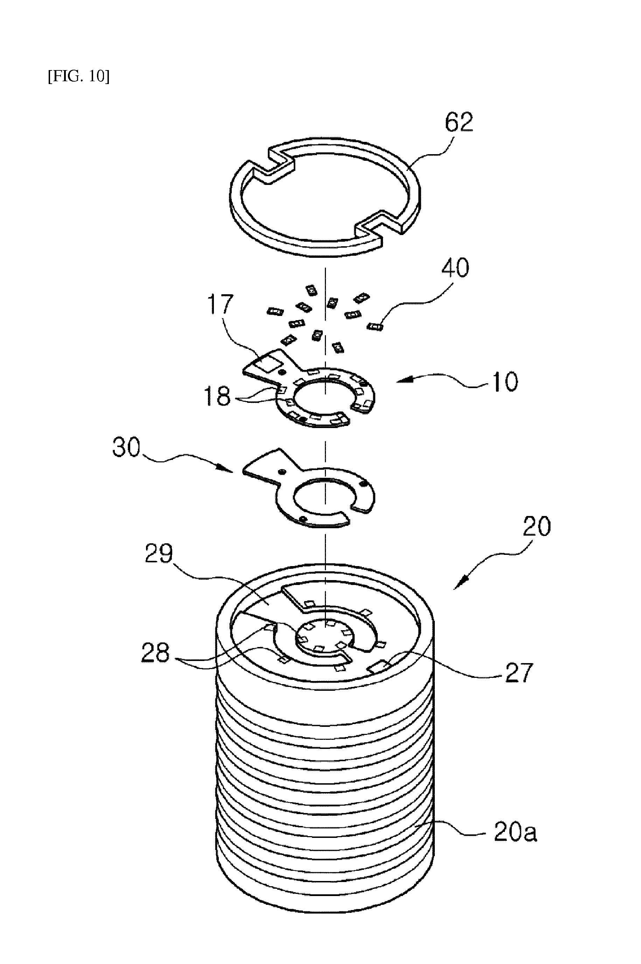

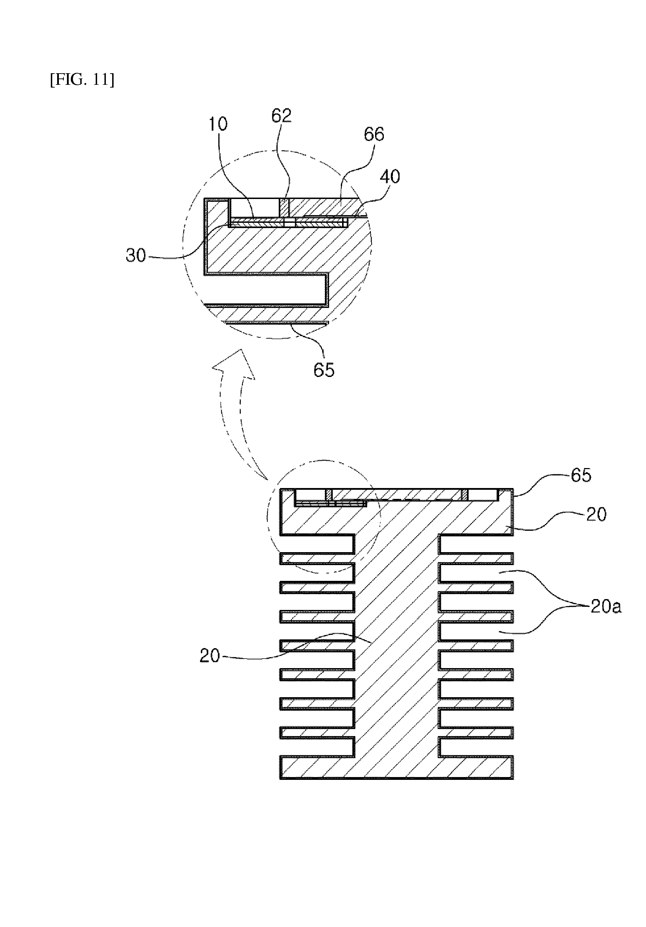

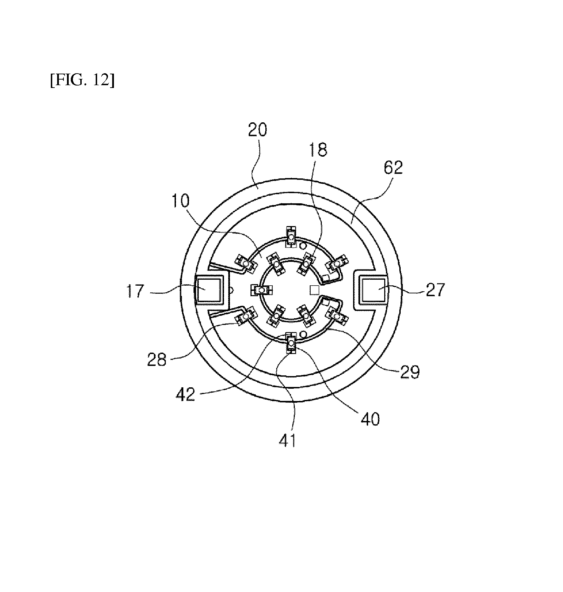

FIG. 8 is a perspective view of an LED light source structure according to a third embodiment of the present invention. FIG. 9 is a side view of the LED light source structure according to the third embodiment of the present invention. FIG. 10 is an exploded perspective view of the LED light source structure according to the third embodiment of the present invention. FIG. 11 is a side cross-sectional view of the LED light source structure according to the third embodiment of the present invention. FIG. 12 is a plan view of the LED light source structure according to the third embodiment of the present invention.

As illustrated in FIGS. 8 to 12, in the third embodiment of the LED light source structure with high illuminating power and improved heat dissipation performance according to the present invention, the second electrode unit 20 which is the metallic body which is excellent in electric conductivity and thermal conductivity is formed to have a shape of a heat sink 60. In this case, a positive electrode 41 of the LED chip 40 is connected to the second electrode unit 20 having the shape of the heat sink, and a negative electrode 42 is insulated from the second electrode unit 20 and connected to the first electrode unit 10 installed in an upper part of the second electrode unit 20. Positive current supplied to the second electrode unit 20 is supplied to the positive electrode 41 of the LED chip 40, and flows to the first electrode unit 10 through the inside of the LED chip 40, and as a result, the LED chip 40 emits light to light on. In this case, heat generated by light emission of the LED chip 40 is directly emitted through the second electrode unit 20 where the heat sink is formed.

That is, in the LED light source structure according to the third embodiment of the present invention, the second electrode unit 20 is manufactured in the heat sink shape by processing metal such as copper or aluminum which is excellent in electric conductivity and thermal conductivity and thereafter, the heat sink-shaped second electrode unit 20 is used directly as the positive electrode 41 of the LED chip 40. Meanwhile, the first electrode unit 10 of the LED chip 40 is insulatively coupled with the heat sink-shaped second electrode unit 20 to thereby prevent a short circuit with the second electrode unit 20. Photons and a large amount of heat are generated in the positive electrode 41 of the LED chip 40, and since the second electrode unit 20 which is excellent in electric conductivity and thermal conductivity forms the positive electrode 41 of the LED chip 40, heat generated by light emission of the LED chip 40 may be rapidly emitted.

The second electrode unit 20 has a cylindrical shape, and a plurality of heat-dissipation grooves 20a are formed on an outer periphery of the second electrode unit 20, and as a result, heat generated from the LED chip 40 coupled to an upper part thereof may be more efficiently emitted.

A groove 29 for insulatively coupling the first electrode unit 10 to the second electrode unit 20 is formed in the upper part of the second electrode unit 20, and the groove 29 is formed in a circular shape which starts from one end of the upper part of the second electrode unit 20 to be divided and partially cut at the inside. An insulator 30 for insulating the first electrode unit 10 and the second electrode unit 20 is formed in an upper part of the groove 29, and the first electrode unit 10 is formed in an upper part of the insulator 30. A side surface of the first electrode unit 10 is spaced apart from the second electrode unit 20 so that the first electrode unit 10 is electrically separated from the second electrode unit 20 including the metal body, and in this case, the height of the first electrode unit 10 is horizontal to an upper height of the second electrode 20 to thereby stably installing the LED chip 40.

Meanwhile, a plurality of LED chips 40 may be installed in the upper part of the second electrode unit 20, and the position of the positive electrode and the position of the negative electrode of the LED chip 40 may be displayed in pairs in the second electrode unit 20 and the first electrode unit 10, respectively in order to install the plurality of LED chips 40. In the embodiment of the present invention, a positive terminal 28 and a negative terminal 18 including gold which is excellent in electric conductivity are displayed on the second electrode unit 20 and the first electrode unit 10, and as a result, the positive electrode 41 and the negative electrode 42 of the LED chip 40 may be easily coupled with each other to be mounted on the second electrode unit 20 and the first electrode unit 10. Further, a positive power input terminal 27 that receives positive power from the outside is formed at one end of the second electrode unit 20 on which the positive terminal 28 is displayed, and a negative power input terminal 17 connected with an external negative power supply is formed at one end of the first electrode unit 10. Meanwhile, the insulator 30 and the first electrode unit 10 are integrally manufactured to be inserted into the groove 29 formed in the second electrode unit 20, and when the insulator 30 and the first electrode unit 10 is inserted into the groove 29 of the second electrode unit 20, a fixation member 62 is inserted into the upper part of the second electrode unit to fix the insulator 30 and the first electrode unit 10.

When the positive electrode 41 of the LED chip 40 is coupled to the second electrode unit 20 and the negative electrode 42 of the LED chip 40 is coupled to the first electrode unit 10, the upper part of the second electrode unit 20 is coated with an insulating material 66 including a transparent material such as silicon, or the like which light may transmit to be stably fixed.

In this case, the outer periphery of the heat sink-shaped second electrode unit 20 is coated with the insulating material 65 in order to prevent short-circuit, and in the embodiment of the present invention, the outer periphery of the second electrode unit 20 is coated with ceramics which has an insulating function and is excellent in heat dissipation function and durability.

Meanwhile, in the embodiment, the second electrode unit 20 has the heat sink shape, but the second electrode unit 20 is not formed in the heat sink shape but provided with an additional heat sink to contact the second electrode unit.

<Fourth Embodiment>

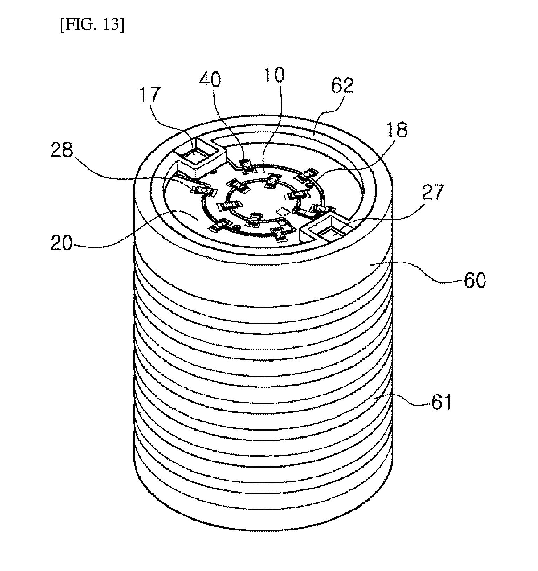

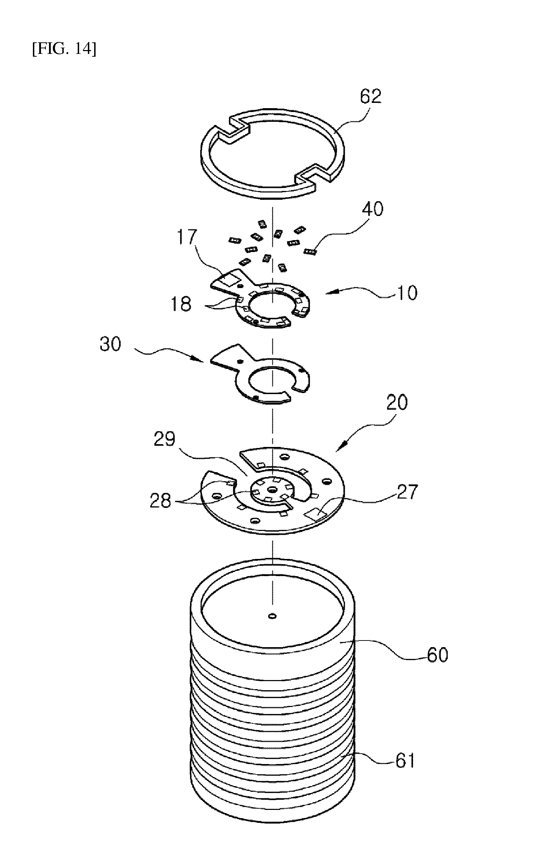

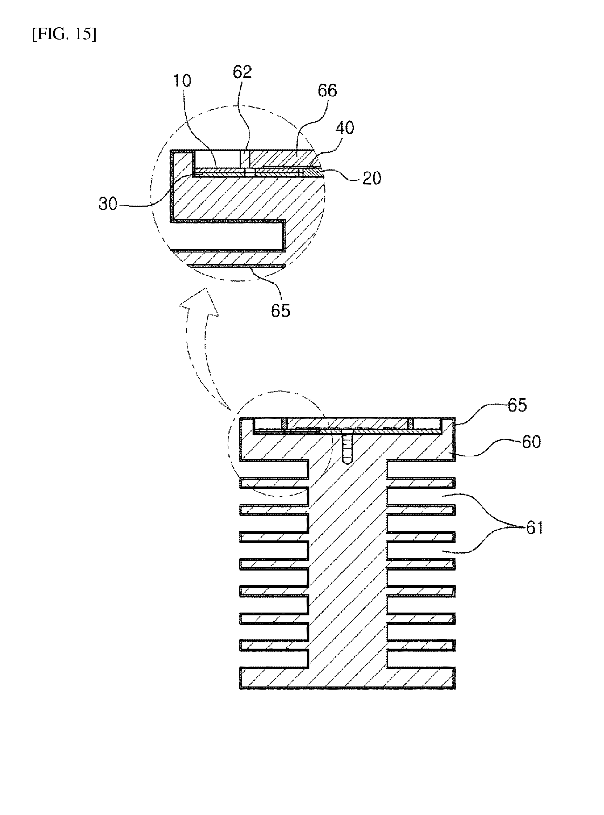

FIG. 13 is a perspective view of an LED light source structure according to a fourth embodiment of the present invention. FIG. 14 is an exploded perspective view of the LED light source structure according to the fourth embodiment of the present invention. FIG. 15 is a side cross-sectional view of the LED light source structure according to the fourth embodiment of the present invention.

As illustrated in FIGS. 13 to 15, in the fourth embodiment of the present invention, the heat sink 60 is independently formed, and the second electrode unit 20 and the first electrode unit 10, the insulator 30, and the LED chip 40 are mounted on an upper part of the heat sink 60.

As a result, the groove 29 for installing the first electrode unit in the second electrode unit 20 installed on the upper part of the heat sink 60 is formed, and the insulator 30 and the first electrode unit 10 are formed in the upper part of the groove 29, which are connected to the negative electrode 42 of the LED chip 40.

The reason for separating the heat sink 60 and the second electrode unit 20 from each other is that it is difficult to form the groove in an upper part of aluminum having high strength and it is difficult to form a positive power input terminal and a positive terminal in the upper part of the aluminum when the heat sink 60 is manufactured by the aluminum having high strength. Therefore, the heat sink 60 may be formed by using a metallic body having low strength or a material having electric conductivity and thermal conductivity, such as graphite or graphene instead of the aluminum.

Preferably, the second electrode unit 20 including copper is coupled to the upper part of the heat sink 60 and the groove 29 is formed by processing the upper part of the second electrode unit 20 having low strength, and the positive power input terminal 27 and the positive terminal 28 are formed, and as a result, a manufacturing process may be easily performed. The second electrode unit 20 is coupled to be electrically connected to the upper part of the heat sink 60 through bonding, soldering, and screw-coupling.

The LED light source structure with high illuminating power and improved heat dissipation performance is used to be coupled with another heat dissipation apparatus, and as a result, the heat dissipation performance may be further improved. That is, when auxiliary heat dissipation apparatuses of various types such as a water cooling type or an air cooling type are used to be coupled to the outside of the heat sink 60, the LED light source dually dissipates heat, and as a result, a heat dissipation effect is further improved. When the auxiliary heat dissipation apparatus is coupled to the outside of the heat sink 60, a form of the heat sink 60 may be appropriately modified according to a type and a form of the auxiliary heat dissipation apparatus for coupling with the auxiliary heat dissipation apparatus. That is, a body of the heat sink 60 may be manufactured in various forms such as a rectangular pole or a pentagon pole so that the heat sink 60 is coupled with the auxiliary heat dissipation apparatus, and a heat dissipation groove 61 formed on an outer periphery of the heat sink 60 may also be changed in various forms such as a horizontal line, a vertical line, a diagonal line, a lattice, and the like, and the form of the heat sink 60 may depend on a use or a type of the LED light source structure.

As described above, the present invention is not limited to the aforementioned embodiment and various modifications and changes can be made by those skilled in the art within the spirit of the present invention and a scope equivalent to the appended claims.

## Claims

1. A light source structure for a light emitting diode (LED) with a high illuminating power and an improved heat dissipation performance, the LED light source structure in which an LED chip is installed and toward outside of which a heat generated by light-on of the LED chip is emitted, comprising:
a first electrode unit 10 including a material with an electric conductivity;
a second electrode unit 20 including a material with an electric conductivity and a thermal conductivity and electrically insulated from the first electrode unit 10; and
an LED chip 40 installed to use the first electrode unit 10 and the second electrode unit 20 as both electrodes,
wherein the first electrode unit 10 and/or the second electrode unit 20 surface-contact the LED chip 40 to allow heat generated from the LED chip 40 to be directly conducted and dissipated toward an atmosphere.

2. The LED light source structure with a high illuminating power and an improved heat dissipation performance of claim 1,
wherein the first electrode unit 10 is provided with one or more first electrode connectors 11 at one end or both ends thereof, provided with one or more through-holes 12, and includes a first electrode section 13 formed on the top of the first electrode unit 10 adjacent to the through-hole 12 and an insulating layer formed at least on the bottom of the first electrode unit 10 in an area other than the first electrode connector 11,
wherein the second electrode unit 20 is provided with one or more second electrode connectors 21 at one end or both ends thereof to be in close contact with a lower part of the first electrode unit,
wherein on the first electrode unit 10, an insulator 30 with electrically non-conductivity in which electrode connection holes 33 corresponding to the through-hole 12 and the first electrode section 13 are formed, is stacked, and
wherein the LED chip is mounted on the insulator 30 to be connected to the first electrode unit 10 by the first electrode section 13 through the electrode connection hole 33 and connected to the second electrode unit 20 through the through-hole 12.

3. The LED light source structure with a high illuminating power and an improved heat dissipation performance of claim 2,
wherein the first electrode connector 11, the first electrode section 13, and at least a portion of the second electrode unit 20 which corresponds to the through-hole 12 are provided with plated layers for improving electric conductivity.

4. The LED light source structure with a high illuminating power and an improved heat dissipation performance of claim 2,
wherein in the insulator 30, a portion on which the LED chip 40 is mounted is dented in form of a concave hemisphere, and an electrode connection hole 33 is formed at the dented center, and
wherein in the second electrode unit 20, a second electrode unit 26 is formed to be protruded toward the through-hole 12 by increasing a mounting height of the LED chip 40 thereby improving light output.

5. The LED light source structure with a high illuminating power and an improved heat dissipation performance of claim 4,
wherein the second electrode section 26 is formed to be protruded by applying pressure to a rear surface of the second electrode unit 20, and a protruding height thereof is 2/3 equal to or less than the thickness of the second electrode unit 20.

6. The LED light source structure with a high illuminating power and an improved heat dissipation performance of claim 4,
wherein a plated layer is additionally formed on the top of the second electrode section 26 in order to improve electric conductivity between the LED chip 40 and the second electrode unit 20.

7. The LED light source structure with a high illuminating power and an improved heat dissipation performance of any one of claims 2 to 5,
wherein the first electrode is a negative electrode, and the second electrode is a positive electrode.

8. The LED light source structure with a high illuminating power and an improved heat dissipation characteristics of any one of claims 2 to 5, wherein:
in the first electrode unit 10 or the second electrode unit 20, a cross-sectional area of an electrode unit in which a large amount of heat is transferred from the LED chip 40 is larger than that of another electrode unit.

9. The LED light source structure with a high illuminating power and an improved heat dissipation performance of any one of claims 1 to 5,
wherein the first electrode connector 11 is formed at only one end of the first electrode unit 10 and the second electrode connector 21 is formed at only the other end of the second electrode unit corresponding to the other end of the first electrode unit 10 so that the first electrode connector 11 is connected with a second electrode connector 21 of the adjacent LED light source structure, the second electrode connector 21 is connected with a first electrode connector 11 of another adjacent LED light source structure to connect one LED light source structure with one or more adjacent LED light source structures.

10. The LED light source structure with a high illuminating power and an improved heat dissipation performance of claim 1,
wherein the second electrode unit 20 is formed to have a heat sink shape so that the heat generated from the LED chip 40 is emitted through the heat sink-shaped second electrode unit 20.

11. The LED light source structure with a high illuminating power and an improved heat dissipation performance of claim 10,
wherein in an upper part of the second electrode unit 20, a groove 29 is formed to install the first electrode unit 10 and the insulator 30 so that the height of the first electrode unit 10 is horizontal to an upper height of the heat sink-shaped second electrode unit 20.

12. The LED light source structure with a high illuminating power and an improved heat dissipation performance of claim 11,
wherein in the upper part of the first electrode unit 10 and the upper part of the second electrode unit 20, a plurality of positive terminals 28 and negative terminal 18 are formed to connect positive electrodes 41 and negative electrodes 42 of the plurality of LED chips 40.

13. The LED light source structure with a high illuminating power and an improved heat dissipation performance of claim 1, further comprising:
a heat sink 60 which is a metallic body having electric conductivity and thermal conductivity,
wherein an upper part of the heat sink 60 is coated with an insulating material 66 including a transparent material, and
wherein in the upper part of the heat sink 60 the second electrode unit 20 is installed, in the upper part of the second electrode unit 20 the first electrode unit 10 is installed to be insulated from the second electrode unit 20 and the heat sink 60 so that the heat generated from the LED chip 40 is emitted through the heat sink 60 contacting the second electrode unit 20.

14. The LED light source structure with a high illuminating power and an improved heat dissipation performance of claim 13,
wherein an exterior of the heat sink 60 in the upper part is coated with an insulating material 65 having a heat dissipation function and an insulating function in order to prevent a short circuit.

15. The LED light source structure with a high illuminating power and an improved heat dissipation performance of claim 13,
wherein the heat sink 60 includes a material having electric conductivity and thermal conductivity.
